# EUROPÄISCHE PATENTSCHRIFT

(11) **EP 2 433 478 B1**
(45) Veröffentlichungstag und Bekanntmachung des Hinweises auf die Patenterteilung: **26.06.2013**
(21) Anmeldenummer: 10710310.3
(22) Anmeldetag: 22.03.2010
(51) Int. Cl.: H05K 5/02, H05K 5/00

(54) **GEHÄUSE ODER GEHÄUSETEIL FÜR EIN STEUERGERÄT EINES KRAFTFAHRZEUGS**
HOUSING OR HOUSING PART FOR A CONTROL DEVICE OF A MOTOR VEHICLE
BOÎTIER OU PARTIE DE BOÎTIER POUR UN APPAREIL DE COMMANDE D'UN VÉHICULE AUTOMOBILE

(30) Priorität: 20.05.2009 DE 102009003284
(43) Veröffentlichungstag der Anmeldung: 28.03.2012
(73) Patentinhaber: Robert Bosch GmbH, 70442 Stuttgart (DE)
(72) Erfinder: HAEBERLIN, Markus, 71732 Tamm (DE); OIRSOUW, Harrie, 70173 Stuttgart (DE); LEONARD, Peter, Clarinda, Victoria 3169 (AU); DOGAN, Kenan, 71522 Backnang (DE)
(86) Internationale Anmeldenummer: PCT/EP2010/053705
(87) Internationale Veröffentlichungsnummer: WO 2010/133389

(56) Entgegenhaltungen:
- EP-A2- 0 854 666
- EP-A2- 1 422 983
- WO-A1-2010/006924
- DE-A1- 3 717 009
- DE-A1-102007 051 716
- FR-A1- 2 822 341
- JP-A- 2008 230 235
- SU-A3- 1 836 811
- US-A1- 2005 130 460
- US-A1- 2007 230 137

## Beschreibung

Die Erfindung betrifft ein Gehäuse oder Gehäuseteil für ein Steuergerät eines Kraftfahrzeug nach der Gattung des unabhängigen Anspruchs.

### Stand der Technik

Zur Versteifung von tragenden Teilen, Gehäusen oder Gehäuseteilen ist es bekannt, diese in Verbindung mit einer möglichst leichten Bauweise mit einer Wabenstruktur zu versehen. So zeigt die DE 42 32 953 A1 ein Fertigungsverfahren zur Verstärkung von Fahrzeugkarosserien oder anderer verwindungsanfälliger Bauteile mit der Zielsetzung, den auf die Steifigkeit bezogenen spezifischen Platzbedarf nachträglicher Karosserieverstärkungen zu verringern, sowie die auf die Steifigkeit bezogenen Gewichtszunahme zu optimieren. Dabei kommt eine Sandwich-Struktur zum Einsatz, bei der eine biegeflexible Zwischenschicht sehr geringen spezifischen Gewichts, die zwei äußeren, dünnen Deckschichten auf Abstand hält, zu einer sehr steifen und zudem leichten Gesamtstruktur führt. Einen vergleichbaren Aufbau für Fahrzeugkarosserien zeigen die JP 2007215328 und die DE 10 2004 002 276 A1.

Aus der SU 1836811 A3 geht hervor, ein Gehäuse mit einer glatten und dünnen Außenoberfläche auf der Innenseite mit einem leichten Versteifungsrahmen zu versehen, der eine wabenähnliche Struktur aufweist. Ebenfalls ist es bekannt, dass Gehäuse oder Gehäuseteile Rippenstrukturen aufweisen, die das Gewicht nur unwesentlich erhöhen aber zu einer sehr hohen Steifigkeit führen.

Aus der US-A 2007/0230137 ist bereits ein Gehäuse für ein Steuergerät bekannt, in dessen Deckel mehrere angeschrägte Vertiefungen eingebracht sind. Damit wird eine Wärmeabfuhr, insbesondere bei feuchten Umgebungsbedingungen, ermöglicht.

Aus der EP 1 422 983 A2 ist bereits ein trittfestes, wärmeableitendes und - abstrahlendes Kunststoffgehäuse mit Kühl-/Tragrippen und umspritztem Kühlkörper sowie ein Verfahren zu dessen Fertigung bekannt. Hierbei besteht das Gehäuse aus zumindest zwei Kunststoffschalen, wobei mindestens eine der beiden Kunststoffschalen ein nach außen gerichtetes Profil aufweist, welches rippenförmig verläuft.

### Offenbarung der Erfindung

Gegenüber dem Stand der Technik weist das erfindungsgemäße Gehäuse oder Gehäuseteil für ein Steuergerät eines Kraftfahrzeugs, mit einer zumindest teilweise von einer ebenen Fläche abweichenden Oberflächenstruktur den Vorteil auf, eine sehr hohe Steifigkeit und Bruchsicherheit in Verbindung mit einer Einsparung am Gehäusevolumen bzw. -material durch eine verhältnismäßig geringe Wandstärke zu erreichen. Dazu ist vorgesehen, dass die Oberflächenstruktur aus mehreren Ebenen besteht, deren Flächenmaße im Wesentlichen gleich groß sind. Weiterhin kann Material eingespart werden, wenn die Oberflächen von Innenseite und Außenseite des Gehäuses oder Gehäuseteils im Bereich der Oberflächenstruktur zueinander invertiert sind, so dass auf keiner Seite eine vollständig glatte Oberfläche verbleibt. Ergänzend oder alternativ ist es möglich, dass sich die Oberflächenstruktur bis auf Bereiche für Anschlüsse und Kennzeichnungsflächen über zumindest eine gesamte Seite des Gehäuses oder Gehäuseteils erstreckt.

In besonders vorteilhafter Weise weisen die einzelnen Ebenen der Oberflächenstruktur gleiche Konturen auf, die dreieckförmig, viereckig oder hexagonal ausgebildet sind. Somit fügen sich die Konturen ohne Zwischenräume aneinander, was die Bruchsicherheit und Steifigkeit weiter erhöht.

Die Verwindungssteifigkeit des Gehäuses oder Gehäuseteils lässt sich zudem verbessern, wenn die Oberflächenstruktur aus mindestens drei Ebenen besteht.

Wenn die einzelnen Ebenen derart miteinander verbunden sind, dass die Wandstärke zwischen den Ebenen im Wesentlichen der Wandstärke der Ebenen entspricht, ist es in vorteilhafter Weise möglich, eine konstante Steifigkeitsverteilung im Bereich der Oberflächenstruktur zu erzielen.

In vorteilhafter Weise ist es möglich, dass elektronische Bauteile des Steuergeräts im Bereich der Oberflächenstruktur derart angeordnet sind, dass sie den durch die verschiedenen Ebenen entstandenen Bauraum ausnutzen, so dass das Gesamtvolumen des Gehäuses insgesamt verringert werden kann. Ist das Gehäuse oder das Gehäuseteil aus Metall gefertigt, kann es in Verbindung mit elektrischen Bauelementen, die eine starke Hitzeentwicklung aufweisen - zum Beispiel Leistungstransistoren -, aufgrund seiner vergrößerten Oberfläche zudem als Kühlkorper genutzt werden.

Weitere Vorteile der Erfindung ergeben sich durch die in den abhängigen Ansprüchen angegebenen Merkmale sowie aus der Zeichnung und der nachfolgenden Beschreibung.

### Zeichnung

Die Erfindung wird im Folgenden anhand der Figuren 1 bis 4 beispielhaft erläutert, wobei gleiche Bezugszeichen in den Figuren auf gleiche Bestandteile mit einer gleichen Funktionsweise hindeuten.

Es zeigen
Fig. 1: ein ersten Ausführungsbeispiel eines erfindungsgemäßen Gehäuses,
Fig. 2: ein zweites Ausführungsbeispiel eines erfindungsgemäßen Gehäuses bzw. Gehäuseteils in einem perspektivischen Schnitt,
Fig. 3: eine Auschnittsvergrößerung des perspektivischen Schnitts aus Figur 2 und
Fig. 4: ein weiteres Ausführungsbeispiel für einen perspektivischen Schnitt des erfindungsgemäßen Gehäuses bzw. Gehäuesteils.

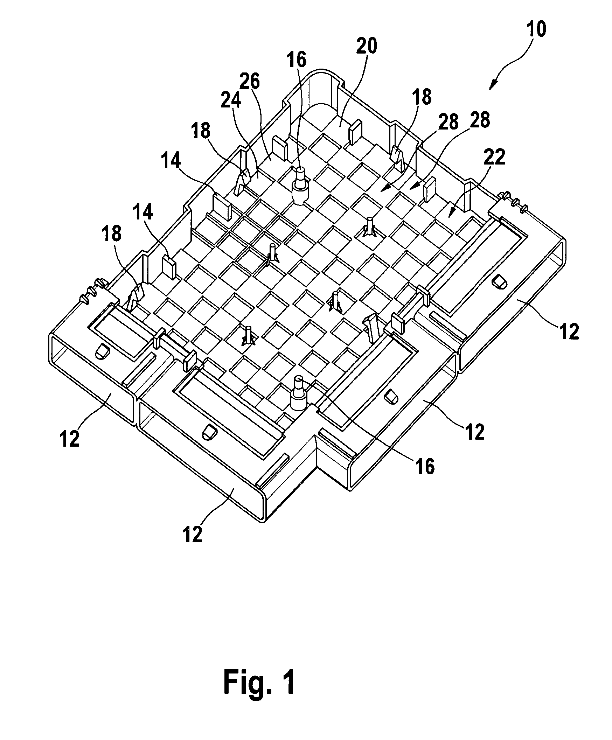

In Figur 1 ist ein Gehäuse 10 eines nicht weiter dargestellten Steuergeräts eines Kraftfahrzeugs gezeigt. Das Gehäuse 10 weist Öffnungen für Anschlüsse 12 des Steuergeräts auf, über die das Steuergerät mit Energie- und/oder Datenverbindungen zu weiteren nicht genauer spezifizierten Geräten verbunden ist. Weiterhin sind in dem Gehäuse Stege 14, Zapfen 16 und Befestigungshaken 18 zur Fixierung einer nicht gezeigten Leiterplatte des Steuergeräts vorgesehen.

Zur Verringerung des Gehäusevolumens bzw. -materials und zur Erhöhung der Gehäusesteifigkeit sowie der Bruchfestigkeit gegenüber Gehäusen mit Rippensturkturen ist die in Figur 1 gezeigte Unterseite 20 des Gehäuses 10 vollständig mit einer Oberflächenstruktur 22 versehen, die derart von einer ebenen Fläche abweicht, dass sie aus zwei Ebenen 24 und 26 besteht, deren Flächenmaße im Wesentlichen gleich groß sind. Dazu weisen beide Ebenen 24 und 26 gleiche Konturen 28 - in diesem Fall eine Vielzahl von Vierecken - auf, wobei die Anzahl der zu erkennenden vertieften Vierecke der ersten Ebene 24 in etwa der Anzahl der erhabenen Vierecke der zweiten Ebene 26 entspricht und die einzelnen Vierecke der beiden Ebenen 24 und 26 nahezu gleich groß sind.

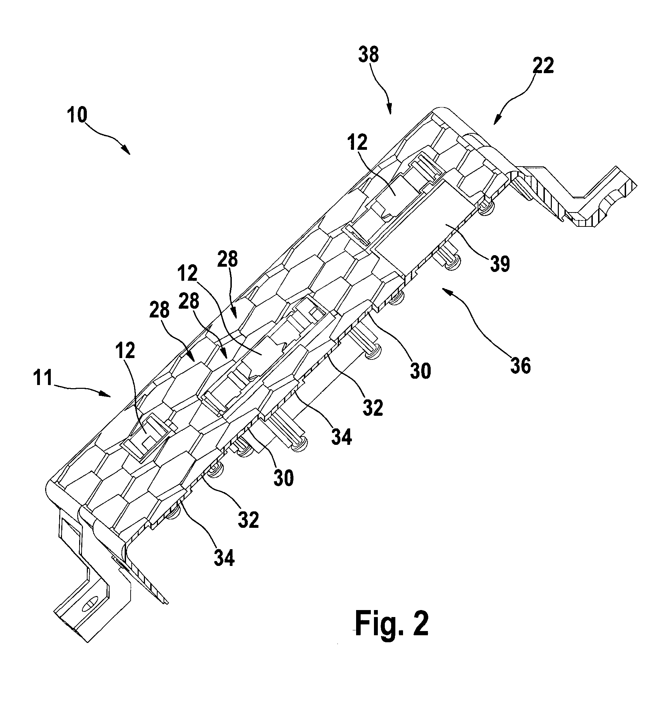

In Figur 2 ist ein weiteres Ausführungsbeispiel für ein erfindungsgemäßes Gehäuseteil 11 eines Gehäuses 10 für ein Steuergerät eines Kraftfahrzeugs in einem perspektivischen Schnitt dargestellt. Im Unterschied zu Figur 1 besteht die Oberflächenstruktur 22 nun aus drei Ebenen 30, 32 und 34, wobei die Kontoren 28 der drei Ebenen 30, 32 und 34 nun hexagonal ausgebildet sind. Wiederum ist zu erkennen, dass die Flächenmaße der drei Ebenen 30, 32 und 34 nahezu gleich groß sind, da sie sich in der Anzahl der Sechsecke sowie deren Flächen nicht wesentlich voneinander unterscheiden.

Die Oberflächen von Innenseite 36 und Außenseite 38 des Gehäuseteils 11 sind weiterhin so ausgestaltet, dass sie im Bereich der Oberflächenstruktur 22 zueinander invertiert sind. Somit kann gegenüber einem Gehäuse, bei dem zum Beispiel nur die Innenseite eine mehrstufe Oberflächenstruktur 22 aufweist, während die Außenseite vollständig eben ausgebildet ist, zusätzlich Material eingespart werden, ohne dass Steifigkeit und Bruchfestigkeit leiden. Um das erfindungsgemäße Gehäuse 10 dennoch mit Typenkennzeichnungen oder sonstigen Beschriftungen versehen zu können, ist weiterhin vorgesehen, dass sich die Oberflächenstruktur 22 nicht über den Bereich von Kennzeichnungsflächen 39 sowie elektrischer und/oder mechanischer Anschlüsse 12 erstreckt.

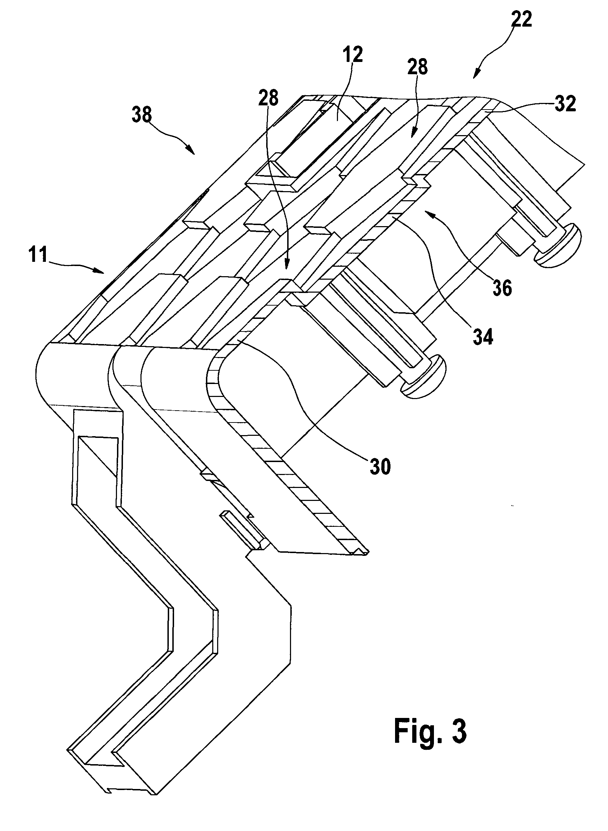

Zur Verdeutlichung zeigt Figur 3 eine Auschnittsvergrößerung der perspektivischen Ansicht des Gehäuseteils 11 aus Figur 2. Gut zu erkennen sind die drei unterschiedlichen Ebenen 30, 32 und 34 mit ihren hexagonalen Konturen 28. Auch wird hier die Invertierung zwischen Innenseite 36 und Außenseite 38 im Bereich der Oberflächenstruktur 22 sehr gut sichtbar.

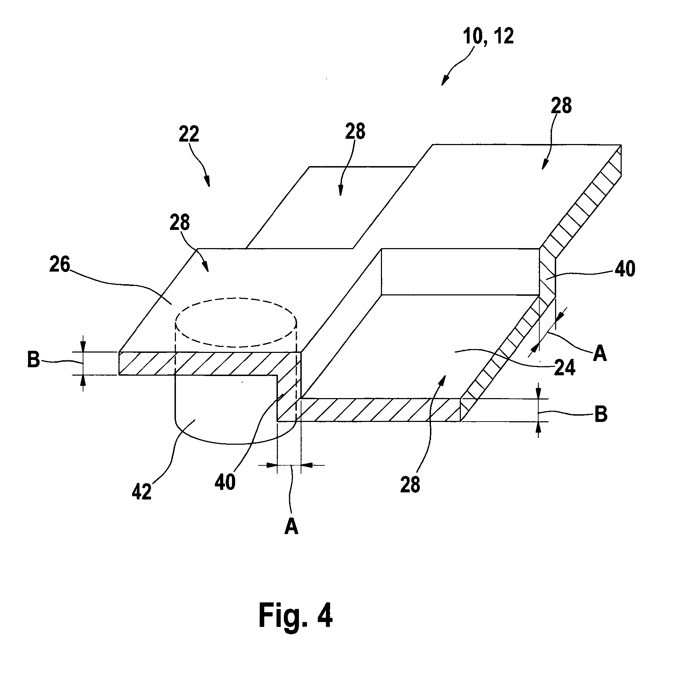

In Figur 4 ist ein weiterer perspektivischer Schnitt der Oberflächenstrutkur 22 des Gehäuses 10 gemäß Figur 1 für zwei Ebenen 24 und 26 mit viereckigen Konturen 28 dargestellt. Dabei wird deutlich, dass die Wandstärke A der Stege 40 zwischen den Ebenen 24 und 26 im Wesentlichen der Wandstärke B der Ebenen 24, 26 entspricht. Auf diese Weise ist eine hohe und homogene Bruchfestigkeit und Steifigkeit des Gehäuses 10 bzw. Gehäuseteils 11 im Bereich der Oberflächenstruktur 22 gegeben.

Weiterhin ist in Figur 4 ein Bauteil 42 des Steuergeräts, beispielsweise ein Kondensator, dargestellt, das derart im Bereich der Oberflächenstruktur 22 angeordnet ist, dass es den durch die verschiedenenen Ebenen 24 bzw. 26 entstandenen Bauraum optimal ausnutzt. Auf diese Weise ist es möglich, das Gesamtvolumen des Gehäuses zu minimieren.

Es sei abschließend noch darauf hingewiesen, dass die gezeigten Ausführungsbeispiele nicht auf die Figuren 1 bis 4 beschränkt sind. So können zum Beispiel neben viereckigen und hexagonalen Konturen der einzelnen Ebenen auch dreieckförmige Konturen verwendet werden. Auch ist die Anzahl der Ebenen nicht auf maximal drei beschränkt. Als Material des Gehäuses 10 bzw. des Gehäuseteils 11 kann Kunststoff und/oder Metall verwendet werden. Insbesondere in Verbindung mit einem Gehäuse aus Metall ist aufgrund der vergrößerten Oberfläche eine bessere Kühlwirkung zu erzielen.

## Patentansprüche

1. Gehäuse (10) oder Gehäuseteil (11) für ein Steuergerät eines Kraftfahrzeugs, mit einer zumindest teilweise von einer ebenen Fläche abweichenden Oberflächenstruktur (22), wobei die Oberflächenstruktur (22) aus mehreren parallelen Ebenen (24, 26; 30, 32, 34) besteht, deren Flächenmaße im Wesentlichen gleich groß sind, wobei die Ebenen (24, 26; 30, 32, 34) jeweils eine Vielzahl von gleichen Konturen (28) aufweisen, deren Anzahl auf den einzelnen Ebenen (24, 26; 30, 32, 34) in etwa gleich groß ist, wobei die Flächenmaße der einzelnen Konturen (28) nahezu gleich groß sind, **dadurch gekennzeichnet, dass** die Oberflächen von Innenseite (36) und Außenseite (38) des Gehäuses (10) oder Gehäuseteils (11) im Bereich der Oberflächenstruktur (22) zueinander invertiert sind.

2. Gehäuse (10) oder Gehäuseteil (11) nach Anspruch 1, **dadurch gekennzeichnet, dass** die Ebenen (24, 26; 30, 32, 34) der Oberflächenstruktur (22) gleiche Konturen (28) aufweisen.

3. Gehäuse (10) oder Gehäuseteil (11) nach Anspruch 2, **dadurch gekennzeichnet, dass** die Konturen (28) der einzelnen Ebenen (24, 26; 30, 32, 34) jeweils dreieckig, viereckig oder hexagonal ausgebildet sind.

4. Gehäuse (10) oder Gehäuseteil (11) nach einem der vorhergehenden Ansprüche, **dadurch gekennzeichnet, dass** die Oberflächenstruktur (22) aus mindestens drei Ebenen (30, 32, 34) besteht.

5. Gehäuse (10) oder Gehäuseteil (11) nach einem der vorhergehenden Ansprüche, **dadurch gekennzeichnet, dass** sich die Oberflächenstruktur (22) bis auf Bereiche für Anschlüsse (12) und Kennzeichnungsflächen (39) über zumindest eine gesamte Seite (20) des Gehäuses (10) oder Gehäuseteils (11) erstreckt.

6. Gehäuse (10) oder Gehäuseteil (11) nach einem der vorhergehenden Ansprüche, **dadurch gekennzeichnet, dass** die einzelnen Ebenen (24, 26; 30, 32, 34) derart miteinander verbunden sind, dass die Wandstärke (A) zwischen den Ebenen (24, 26; 30, 32, 34) im Wesentlichen der Wandstärke (B) der Ebenen (24, 26; 30, 32, 34) entspricht.

7. Gehäuse (10) oder Gehäuseteil (11) nach einem der vorhergehenden Ansprüche, **dadurch gekennzeichnet, dass** Bauteile (40) des Steuergeräts im Bereich der Oberflächenstruktur (22) derart angeordnet sind, dass sie den durch die verschiedenen Ebenen (24, 26; 30, 32, 34) entstandenen Bauraum ausnutzen.

## Claims

1. Housing (10) or housing part (11) for a control unit of a motor vehicle, having a surface structure (22) deviating at least partially from a plane surface, being the surface structure (22) composed of multiple parallel planes (24, 26; 30, 32, 34), the areas of which are substantially equal in size, the planes (24, 26; 30, 32, 34) each having a plurality of identical contours (28), the number of which is approximately equal on the individual planes (24, 26; 30, 32, 34), the areas of the individual contours (28) being virtually equal in size, **characterized in that** the surfaces of the inside (36) and outside (38) of the housing (10) or housing part (11) are inverted relative to one another in the area of the surface structure (22).

2. Housing (10) or housing part (11) according to Claim 1, **characterized in that** the planes (24, 26; 30, 32, 34) of the surface structure (22) have the same contours (28).

3. Housing (10) or housing part (11) according to Claim 2, **characterized in that** the contours (28) of the individual planes (24, 26; 30, 32, 34) are each of triangular, quadrilateral or hexagonal shape.

4. Housing (10) or housing part (11) according to one of the preceding claims, **characterized in that** the surface structure (22) is composed of at least three planes (30, 32, 34).

5. Housing (10) or housing part (11) according to one of the preceding claims, **characterized in that** the surface structure (22) extends over at least an entire side (20) of the housing (10) or housing part (11), except for areas for connections (12) and identification marking surfaces (39).

6. Housing (10) or housing part (11) according to one of the preceding claims, **characterized in that** the individual planes (24, 26; 30, 32, 34) are connected to one another in such a way that the wall thickness (A) between the planes (24, 26; 30, 32, 34) substantially corresponds to the wall thickness (B) of the planes (24, 26; 30, 32, 34).

7. Housing (10) or housing part (11) according to one of the preceding claims, **characterized in that** components (40) of the control unit are arranged in the area of the surface structure (22) in such a way that they utilize the overall space created by the various planes (24, 26; 30, 32, 34).

## Revendications

1. Boîtier (10) ou partie de boîtier (11) pour un appareil de commande d'un véhicule automobile, comprenant une structure de surface (22) s'écartant au moins en partie d'une surface plane, la structure de surface (22) se composant de plusieurs plans parallèles (24, 26 ; 30, 32, 34), de superficies sensiblement identiques, les plans (24, 26 ; 30, 32, 34) présentant à chaque fois une pluralité de contours identiques (28), dont le nombre sur les plans individuels (24, 26 ; 30, 32, 34) est approximativement identique, les superficies des contours individuels (28) étant approximativement identiques, **caractérisé en ce que** les surfaces du côté intérieur (36) et du côté extérieur (38) du boîtier (10) ou de la partie de boîtier (11) sont inversées l'une par rapport à l'autre dans la région de la structure de surface (22).

2. Boîtier (10) ou partie de boîtier (11) selon la revendication 1, **caractérisé en ce que** les plans (24, 26 ; 30, 32, 34) de la structure de surface (22) présentent des contours identiques (28).

3. Boîtier (10) ou partie de boîtier (11) selon la revendication 2, **caractérisé en ce que** les contours (28) des plans individuels (24, 26 ; 30, 32, 34) sont réalisés à chaque fois sous forme triangulaire, rectangulaire ou hexagonale.

4. Boîtier (10) ou partie de boîtier (11) selon l'une quelconque des revendications précédentes, **caractérisé en ce que** la structure de surface (22) se compose d'au moins trois plans (30, 32, 34).

5. Boîtier (10) ou partie de boîtier (11) selon l'une quelconque des revendications précédentes, **caractérisé en ce que** la structure de surface (22) s'étend jusqu'à des régions pour des raccords (12) et des surfaces d'identification (39) sur au moins un côté complet (20) du boîtier (10) ou de la partie de boîtier (11).

6. Boîtier (10) ou partie de boîtier (11) selon l'une quelconque des revendications précédentes, **caractérisé en ce que** les plans individuels (24, 26 ; 30, 32, 34) sont connectés les uns aux autres de telle sorte que l'épaisseur de paroi (A) entre les plans (24, 26 ; 30, 32, 34) corresponde essentiellement à l'épaisseur de paroi (B) des plans (24, 26 ; 30, 32, 34).

7. Boîtier (10) ou partie de boîtier (11) selon l'une quelconque des revendications précédentes, **caractérisé en ce que** des composants (40) de l'appareil de commande sont disposés dans la région de la structure de surface (22) de telle sorte qu'ils utilisent l'espace de construction créé par les différents plans (24, 26 ; 30, 32, 34) .
